(19) Europäisches Patentamt / European Patent Office / Office européen des brevets

(11) **EP 2 706 670 A2**

(12) **EUROPEAN PATENT APPLICATION**

(43) Date of publication:
**12.03.2014 Bulletin 2014/11**

(51) Int Cl.:
***H04B 3/23*** (2006.01)

(21) Application number: **13177794.8**

(22) Date of filing: **24.07.2013**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **06.09.2012 EP 12368024**

(71) Applicant: **ST-Ericsson SA**
**1228 Plan-les-Ouates (CH)**

(72) Inventor: **Cimaz, Lionel**
**35137 Pleumeleuc, Rennes (FR)**

(74) Representative: **Valea AB**
**Anna Lindhs Plats 4**
**211 19 Malmö (SE)**

(54) **Method in a prediction filter, and such a prediction filter.**

(57)     A method in a prediction filter for stabilizing filter performance of the prediction filter is provided. The method comprises computing a filter magnitude metric related to the prediction filter, smoothing the filter magnitude metric, creating a filter deviation metric by subtracting the filter magnitude metric from the smoothed filter magnitude metric, and stabilizing the performance of the prediction filter by modulating the prediction filter based on the filter deviation metric.

```
201 ─ Compute filter magnitude metric

202 ─ Smooth filter magnitude metric

203 ─ Create filter deviation metric

204 ─ Stabilize performance of prediction filter
```

*Fig.6*

**Description**

TECHNICAL FIELD

Embodiments herein relates to the field of digital signal processing, and especially to a method in a prediction filter for stabilizing filter performance, and to such a prediction filter.

BACKGROUND

In the audio Digital Signal Processing, DSP, area it is common to use prediction filters in order to estimate a channel G transfer function not known and potentially variable. Generation of such a filter, named as the training phase, may be based on classical methods such as Normalized Least Mean Square, NLMS, or Fast Affine Projection, FAP. These known methods use error of prediction during the training phase in order to adjust a filter coefficient.

If a channel G transfer function is mainly represented by a Finite Impulse Response, FIR, filter of length N, the training of the filter, using NLMS for example, causes the filter F transfer function to converge towards the channel G transfer function whereby the filter F transfer function will become close to the channel G transfer function. Hence, the predicted filter output F(x) will be very similar to the channel G output G(x). The training of the filter F transfer function consists in establishing the prediction error F(x)-G(x) and using the established error to adjust the filter F transfer function coefficient, using NLMS, FAP, etc. Adaptation of the coefficient is performed by use of a local loop on the prediction filter.

The prediction filter is very powerful in applications where the channel G transfer function needs to be known and tracked if variable. In some other applications, the prediction filter, after training, provides an image of the channel G output signal when this is not directly accessible to the system that is predicted. In fact, as the filter F transfer function represents G more or less precisely, F(x) may be close to the channel G output G(x) whereby the system may use F(x) since the channel G output G(x) is not accessible. This principle is widely used for signal cancellation techniques such as Echo Canceller.

However, in systems where such a filter is used as a predictor, the poor reality of the predicted signal is a problem.

Presence of a disruptor signal d is dramatic for the filter F transfer function training. The training algorithm, NLMS, FAP, etc. relies on the fact that the prediction error correlates to a reference signal x. With presence of the disruptor signal d, the error is not only caused by a reference signal x but also contains the disruptor signal d. If the disruptor signal d is large enough, the training of the filter will compute wrong FIR filter coefficients and the filter F transfer function will diverge. In such case F(x) will become far away from the channel G output G(x), thus prediction of the signal will be out of sense.

Training of filters may be improved by incorporating an Activity Detector, AD. The role of the activity detector is to estimate the presence of the disruptor signal d. When the disruptor signal d is detected, the training of the FIR filter is stopped, or slowed down, thus wrong filter coefficients will not be computed. In presence of the disruptor signal d, the filter is in fact no more converging towards G, but it is not diverging either. On the other hand, the system takes the opportunity to train the filter each time the disruptor signal d is absent. Hence, the training of the filter will proceed and converge little by little without divergence. Thereby F(x) will come closer and closer to the channel G output G(x).

However, since the training of the filter is not continuous due to the regular presence of the disruptor signal d, a high convergence speed when the disruptor signal d is absent is critical. In fact, the convergence will proceed but the overall requirements of convergence time are not changing. For example, if overall convergence is required to be done within 1s but the training of the filter F transfer function may be performed only 1/10 of the time available due to regular presence of the disruptor signal d, the effective training speed needs to be 10 times faster. Higher speed on the filter training is risky because if the filter may converge faster, it may also diverge faster. Therefore, the quality of the activity detector AD is critical because if some detections of the presence of the disruptor signal d are missed, the filter will diverge very quickly. On the other hand, if the activity detector AD misses some detections of the absence of the disruptor signal d, the system will miss some chances to converge.

In some applications, the design of a reliable activity detector is straight forward. This is particularly the case if the disruptor signal d is known to have a quite large magnitude compared to the channel G output G(x). The activity detector is then essentially built around a level estimation associated to a comparator. If the level is above a threshold of the comparator, the disruptor signal d is said to be present, else the disruptor signal d is said to be absent. Some variations of such activity detector AD exist where the activity detector AD transmits an inverse image of the level which speeds up the adaptation speed; the higher level, the lower is the speed; the lower level, the higher is the speed.

When the disruptor signal d and the channel G output G(x) show a similar magnitude, a direct level based activity detector AD will not work anymore. In fact, it will not be able to detect absence of the disruptor signal d if the channel G output G(x) is active since they have a similar level. Thus, since the channel G output G(x) is present, the filter will not train as its level is comparable to the presence of the disruptor signal d. Unfortunately, the channel G output G(x) presence alone is the only case permitting filter training but, as simple level based activity detector AD will not permit adaptation in such situation, the filter will effectively never train.

A first common solution is taking advantage of the disruptor signal d and the channel G output G(x) signal composition specificities, if there are any. Typically, it may happen that the disruptor signal d contains spectral energy at some locations where the channel G output G(x) does not, or vice versa. Hence, using a level activity detector AD tracking the energy in these particular spectral locations may give a reliable prediction.

The activity detector AD is fed by a filter rejecting the spectral locations where the channel G output G(x) probably has its highest energy but the disruptor signal d has not. Out of such a filter, mainly an image of the disruptor signal d remains based on which the activity detector AD may run a level detection.

The filtered activity detector AD is thus based on some spectral particularities of the channel G output G(x) and the disruptor signal d. Unfortunately, some applications do not display large enough differences between the channel G output G(x) and the disruptor signal d in order to build-up a reliable filtered activity detector.

Another common solution in such a situation is connecting to an activity on an error signal. This technique is based on the fact that, when converged, the FIR filter F(x) signal will be similar to the channel G output G(x). Hence, the prediction error signal will be essentially equal to -d as F(x)- G(x) will be close to 0 because F(x) is similar to G(x). Thus, the activity detector AD will essentially detect -d and it will be easy to provide a reliable detection of the presence of the disruptor signal d with direct level estimation.

As detection of the disruptor signal d is critical, common implementations incorporate multiple activity detectors activity detector AD and combine all their results in order to safely speed up the adaptation speed. Each activity detector AD technique show some specific advantage, thus combining multiple techniques allows covering a wide range of situations. Some particular detection techniques may be based on signal shape identity, some other on signal correlation product.

Two groups of activity detector techniques are established. Open loop; these techniques use the system input signal G(x)+d directly. Filtered activity detectors AD as described above fall under this group, as well as shape identity activity detectors AD for example. Closed loop; these techniques establishes an activity metric by using in their computation directly or indirectly the output F(X) from the FIR filter. The error activity detector AD described above fall under this group as well as a correlation product based activity detector AD.

In the situation where the channel G signal has a magnitude comparable to the magnitude of the disruptor signal d, the adaptation speed control of common smart predictors will combine metrics from a group of open loop activity detectors activity detector AD and a group of closed loop activity detectors AD.

When applicable, the open loop activity detectors activity detector AD will use specific particularities of the G(x) signal not existing in the disruptor signal d signal, thus the G(x) signal may be rejected before activity detection, typically a filter rejecting the channel G output G(x) probable spectrum or a subtraction of the channel G output G(x) waveform shape estimated from x. These techniques work most of the time except if the disruptor signal d may have temporarily the same specificities as the channel G output G(x). In this situation, the disruptor signal d is going to be rejected as the channel G output G(x) and the activity detection will not catch the presence of the disruptor signal d. Because the presence of the disruptor signal d is not detected, the adaptation of the FIR filter may be wrong and prediction may diverge. Thus, pure open loop based predictors risk to diverge.

To avoid divergences linked to non-detection of the presence of the disruptor signal d by open loop activity detectors AD, common systems in addition use a closed loop activity detection. Hence, if an open loop activity detection misses the presence of the disruptor signal d, the closed loop activity detection will catch it and training of the filter will be stopped. Doing that, the predictor will not diverge.

However, the closed loop activity detectors activity detector AD poses another problem. In fact, it relies on the fact that F(x) is similar to the channel G output G(x), thus, that the prediction error F(x)- G(x)-d will approach -d as F(x)- G(x) approaches 0. If F(x) is not similar to G(x), when the filter F transfer function does not match G, the closed loop activity detector AD will not detect only -d but also the signal F(x)- G(x). If F(x)- G(x) is large enough, the activity detector AD may deduce the presence of the disruptor signal d while in fact only the F(x)- G(x) signal is present.

In the situation that the presence of the disruptor signal d is detected by a closed loop activity detector AD, the adaptation of the FIR filter is basically frozen in order to avoid divergence. If the presence of the disruptor signal d detection was wrongly estimated because F(x)- G(x) is too large, the system will hang. In fact, the only way of approaching F(x)- G(x) towards 0 is to train the filter, but as F(x)- G(x) is large, the activity detector AD will stop the training of the filter.

In real implementation, the detection of the disruptor signal d by a closed loop activity detector AD is not completely stopping the adaptation, but reduces its speed. Hence, F(x) will still converge towards G(x) with a slow speed, thus, after a given time, F(x)-G(x) will become low enough and the closed loop activity detector AD will no more produce an erroneous detection.

The situation where F(x)-G(x) is not close to 0 occurs often in some applications. At initial start-up of a predictor, the FIR filter is not yet trained, hence F(x) is necessarily far away from G(x) resulting in large F(x)-G(x). In some applications, the channel G transfer function may change quickly, thus, even if the filter F transfer function was trained before the G variation, F(x)- G(x) will become large since G changes.

In summary, closed loop activity detectors AD have several side effects. The detection of the disruptor signal d may not completely stop the filter training, thus the prediction may hang in some cases. Some bad adaptation situations remain due to the presence of the disruptor signal d. The adaptation will be done slowly but it will still be done wrongly. The initial convergence will be slow as non-trained filters create same behaviour as the presence of the disruptor signal d: thus reducing the adaptation speed. Each re-convergence, needed because the channel G transfer function changes, will be slow as it will be detected by the closed loop activity detector AD as the presence of the disruptor signal d.

SUMMARY

It is an object of embodiments herein to provide an improved method for stabilizing filter performance of a prediction filter. According to a first aspect the object is achieved by a method in a prediction filter for stabilizing filter performance of the prediction filter. The method comprises computing a filter magnitude metric related to the prediction filter, smoothing the filter magnitude metric, creating a filter deviation metric by subtracting the filter magnitude metric from the smoothed filter magnitude metric, and stabilizing the performance of the prediction filter by modulating the prediction filter based on the filter deviation metric.

According to a second aspect the object is achieved by a prediction filter for stabilizing filter performance. The prediction filter comprises a computing unit configured to compute a filter magnitude metric related to the prediction filter, to smooth the filter magnitude metric, to create a filter deviation metric by subtracting the filter magnitude metric from the smoothed filter magnitude metric, and to stabilize the performance of the prediction filter by modulating the prediction filter based on the filter deviation metric.

BRIEF DESCRIPTION OF THE DRAWINGS

Other features of one or more embodiments will appear from the following description of embodiments, with reference being made to the accompanying drawings.

Figure 1 illustrates the use of an error prediction filter in a conventional system.

Figure 2 illustrates the presence of a disruptor signal d in a predictor filter.

Figure 3 illustrates the use of an Activity Detector, AD, in a prediction filter.

Figure 4 illustrates a typical case of a filtered activity detection.

Figure 5 illustrates a known solution of detecting an activity for an error signal.

Figure 6 is a flow chart for an exemplified method.

Figure 7 illustrates a filter magnitude, filterMag, metric for a given application.

Figure 8 shows a metric for the deviation of a filter, filterDeviation, corresponding to the example of figure 7, where tau is in the range of 0.1s.

Figure 9 illustrates a normalized filter deviation metric, filterDevNorm, wave in a considered example.

Figure 10 is a block diagram for an exemplified embodiment.

Figure 11 illustrates an overall structure of one exemplified embodiment.

Figure 12 shows an overall filter magnitude.

DETAILED DESCRIPTION

Embodiments herein will be exemplified in the following non-limiting description. For the full understanding, some problems and drawbacks with prior art solutions will first be discussed.

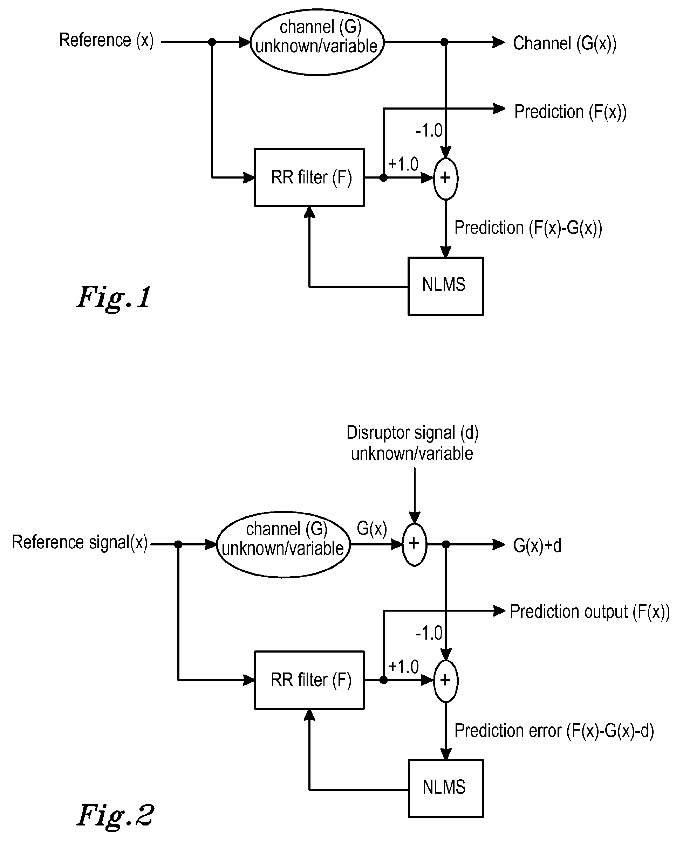

In the audio Digital Signal Processing, DSP, are it is common to use prediction filters as described above. The generation of the filter, the training phase, may be based on classical methods such as Normalized Least Mean Square, NLMS, or Fast Affine Projection, FAP. These methods use error of prediction during training phase to adjust the filter coefficient as shown in **Figure 1**.

In some applications, a prediction filter, after training, provides an image of a channel G output signal not directly accessible to the system that is predicted. As the filter F transfer function represents G more or less precisely, F(x) may be close to G(x) whereby the system may use F(x) since G(x) is not accessible. This principle is widely used for signal cancellation techniques such as Echo Canceller. In systems where such filter is used as predictor, the poor reality of the predicted signal is illustrated in **Figure 2**.

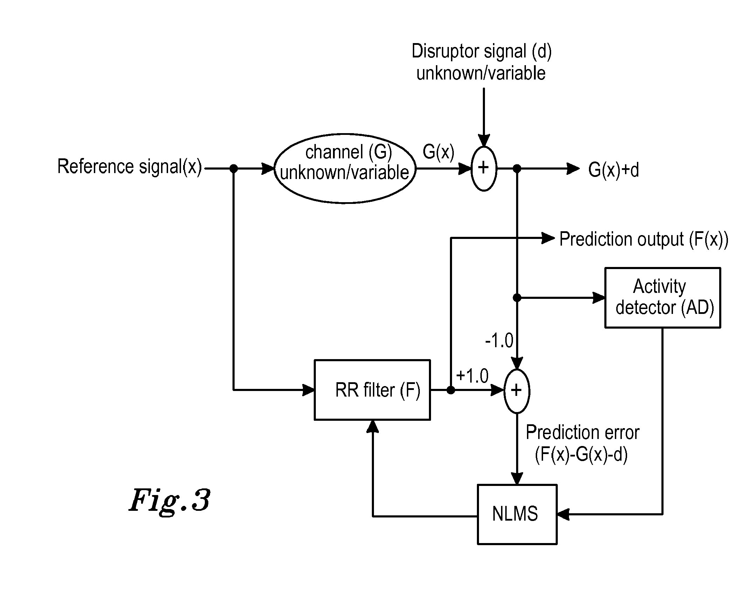

Training of the filter may be improved by incorporating an Activity Detector, AD, such as illustrated in **Figure 3**. The role of the activity detector as earlier explained is to estimate the presence of a disruptor signal d. When the disruptor signal d is detected, the training of FIR filter is stopped, or slowed down, thus wrong filter coefficients will not be computed. In the presence of the disruptor signal d, the filter is no more converging towards G in fact, but it is not diverging either. On the other hand, the system takes the opportunity to train the filter each time the disruptor signal d is absent. Hence the training proceeds and the filter converges little by little without divergence. Thereby F(x) approaches the channel G output G(x).

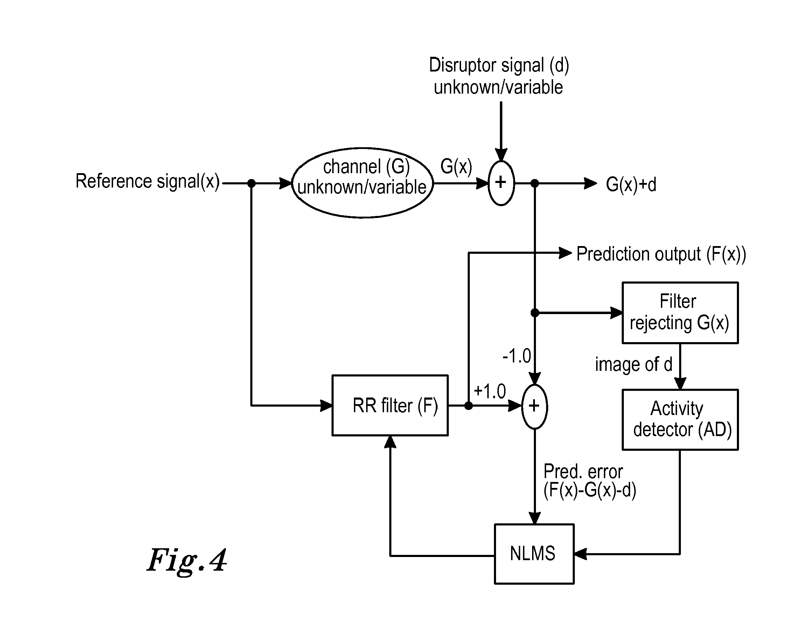

A first common solution is taking advantage of the disruptor signal d and the channel G output G(x) signal composition specificities, if present. Typically, the disruptor signal d contains spectral energy at some locations where the channel G output G(x) does not, or vice versa. Hence, using a level activity detector tracking the energy in these particular spectral locations may result in a reliable performance. **Figure 4** shows a typical case of filtered activity detection. The filtered activity detector AD is thus based on some spectral particularities of the channel G output G(x) and the disruptor signal d. Unfortunately, in some applications it is not large enough differences between the channel G output G(x) and the disruptor signal d to build-up a reliable filtered activity detector.

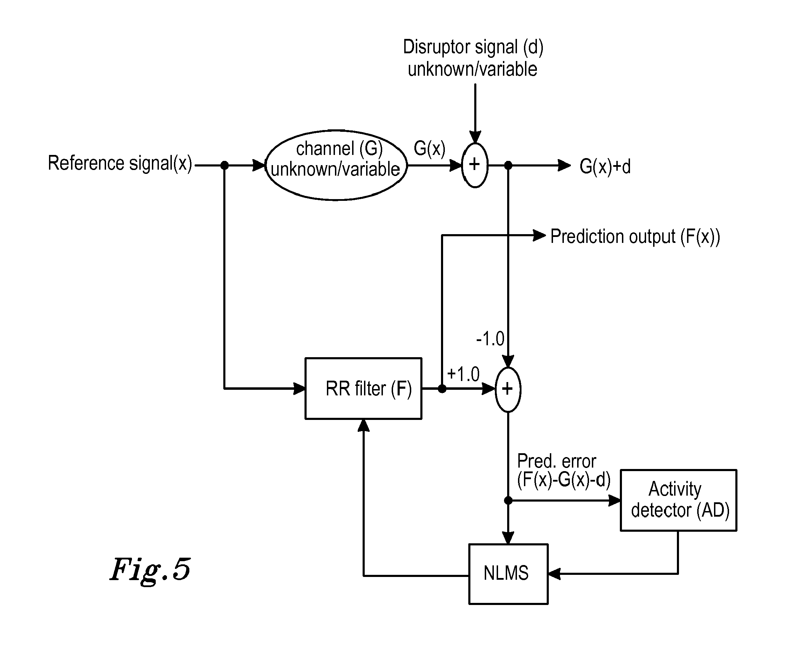

Another common solution in such situation consists in connecting an activity on the error signal, as illustrated in Figure 5. Divergence of a FIR filter occurs when the FIR filter predictor is trained with a signal not created essentially from a reference signal x. Typically, the training should be performed using an error signal such as F(x)-G(x). Since the disruptor signal d is added to the channel G path, the adaptation may be made with F(x)-G(x)-d. Because of the presence of the disruptor signal d, the filter coefficients will be wrongly updated. The filter coefficients adaptation with an NLMS algorithm for example may be done as per the following equation:

$$For\ n\ between\ 0\ to\ N, f(n) <= f(n) + \frac{\mu.e.x(n)}{E}$$

Where f(n) is the nth coefficient of FIR filter F, $\mu$ is the adaptation factor, image of speed, x(n) is the nth reference sample and E is the total energy of the N samples of reference signal x. Consider e being composed by an effective adaptation error ea = F(x)-G(x) and the disruptor signal -d:

$$f(n) <= f(n) + \frac{\mu.ea.x(n)}{E} + \frac{\mu.(-d).x(n)}{E}$$

Thus f(n) is updated by a part effectively obtained from the adaptation error ea and a part from the disruptor signal d. Consider that the adaptation error ea is small. Also consider that the disruptor signal d does not correlate at all to x. The disruptor signal d may appear as a "noise" with regards to x, thus, as random values with average centered to 0. In such a case, even if the training of the filter is not frozen, $\mu$ is not 0, but the disruptor signal d signal is active, and the filter will not diverge frankly. As a fact, since the disruptor signal d and the reference signal x does not correlate, d.x will still have a noise behaviour, random and average at 0. Since the average of d.x is 0, f(n) may behave as a constant with noise superposed. When the disruptor signal d is applied during training of the predictor, the FIR filter F transfer function may not represent the channel G transfer function exactly, but will still match in average. If the disruptor signal d has not been too large during the training, the deviation of the filter F transfer function from convergence may not be important and the predictor will re-converge easily when the disruptor signal d disappears. In some extend, slow convergence may still be monitored in the presence of the disruptor signal d.

Consider that the disruptor signal d correlates to a reference signal x. In this case the disruptor signal d may be described as:

$$d = x(n+k).v(n)$$

d is then an image of the reference signal x with a delay k and a small variation v(n).

As a reference signal is not likely to be a noise, the product d.x(n) = x(n).x(n+k).v(n) will not have an average close to 0, instead the product will be even far away from 0 if k is 0.

Consider again the adaptation of the filter F transfer function coefficient. It will become:

$$f(n) <= f(n) + \frac{\mu.ea.x(n)}{E} + \frac{\mu.\left(-v(n)\right).x(n+k).x(n)}{E}$$

If ea close to 0 is considered, f(n) is no more representing a constant with superposed noise as the case is when the disruptor signal d does not correlate to x. Instead, f(n) is behaving as an accumulator increasing its magnitude at each update. The error ea will become non null afterwards, and, depending on the filter coefficient and the reference signal x, it may enlarge the phenomenon. The divergence of the filter F transfer function is thus large.

In summary and as seen by experience, the overall behaviour of the prediction filter if trained while the disruptor signal d is present depends a lot on the composition of the disruptor signal d. If the disruptor signal d does not correlate to a reference signal, the filter will become noisy but will stay close to convergence. This situation is not good but not dramatic either. If the disruptor signal d correlates to a reference signal x, the filter will largely diverge, with the filter coefficient becoming larger and larger at each update. This situation is really dramatic. If the adaption speed is high, the divergence of the filter is very fast and very large.

When the system output is in fact the predictor error, for example in an Echo Canceller, the objective is the cancellation of channel G signal output G(x). With such FIR filter divergence, the system may output a lot larger signal than the one it aims to cancel. The signal cancellation objective of the system is not just simply voided; the system may become an amplifier of the signal it wants to cancel.

As discussed above, the divergence of the filter is dramatic if the disruptor signal d becomes correlated to the reference signal x during adaptation of the predictor.

In normal situations, the presence of the disruptor signal d will stop the adaptation of the predictor thanks to the activity detector AD. If the system has to treat channel G signal output G(x) having a similar magnitude compared to the disruptor signal d, the open loop activity detector AD, if any, will employ a rejection technique of the channel G output G(x) in order to correctly detect d.

If the disruptor signal d correlates to x, there is a big probability that the disruptor signal d also correlates to the channel G output G(x). Hence, the rejection of the channel G output G(x) by the open loop activity detection will most probably reject d. Then the disruptor signal d will not be detected.

d correlating to the reference signal x is not only the worst situation of FIR filter divergence, it is also a situation where the open loop activity detector AD cannot detect the disruptor signal d in order to stop the adaptation.

According to embodiments herein, a method in a prediction filter 101 for stabilizing filter performance of the prediction filter is provided. By means of exemplified embodiments, in the case that the disruptor signal d magnitude level is similar to the magnitude level of the channel G output G(x) signal, will help in eliminating the slow convergence speed effect of the closed loop activity detector AD while at the same time preventing divergence cases linked to mainly open loop controlled adaptation.

Embodiments herein is based on a global analysis of the evolution of the FIR filter coefficients. A FIR filter deviation metric is established, and this metric may be looped, with an associated loop gain, to the adaptation speed control of the training algorithm, that may be NLMS. By creating such a loop, the FIR filter coefficient evolution is globally bounded avoiding large divergence if an open loop activity detector AD will fail to detect the presence of the disruptor signal d. The use of a closed loop activity detector AD is not mandatory but may still be populated in a system; it will anyway have a lowering effect on the adaptation speed.

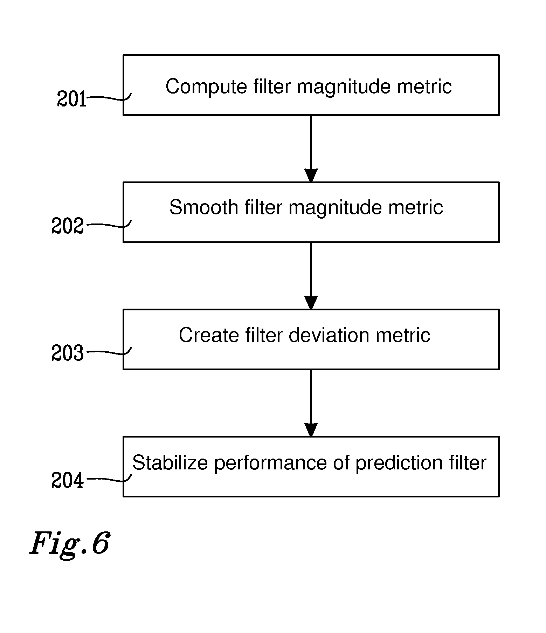

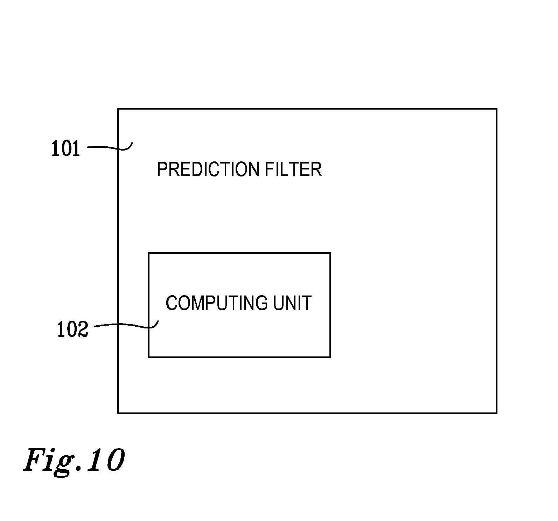

With reference to **Figure 6 and Figure 10** an exemplified method will now be described.

**Action 201**

The method comprises computing a filter magnitude metric related to the prediction filter 101. The prediction filter 101 may be a Finite Impulse Response, FIR, filter. The prediction filter 101 comprises a computing unit 102 configured to compute a filter magnitude metric related to the prediction filter 101. The a computing unit 102 is further configured to smooth the filter magnitude metric, to create a filter deviation metric by subtracting the filter magnitude metric from the smoothed filter magnitude metric, and to stabilize the performance of the prediction filter by modulating the prediction filter based on the filter deviation metric. The filter performance is represented by a plurality of filter magnitude coefficients, and computing of the filter magnitude metric may be performed by summing an absolute value of each of the filter magnitude coefficients according to

$$filterMag = \sum_{n=0}^{N} |f(n)|$$

$$For\ n\ between\ 0\ to\ N, f(n) <= f(n) + \frac{\mu.e.x(n)}{E}$$

where *filterMag* is the filter magnitude metric, *f(n)* is the nth coefficient of FIR filter F, $\mu$ is the adaptation factor, image of speed, *x(n)* is the nth reference sample, *E* is the total energy of the N samples of reference signal x, and n is an integer between 0 and N . The computing unit 102 may be configured to stabilize performance by looping the filter deviation metric to an adaptation speed control of a training algorithm. The filter performance may be represented by a plurality of filter magnitude coefficients, and the computing unit 102 may be configured to compute the filter magnitude metric by summing an absolute value of each of the filter magnitude coefficients according to

$$filterMag = \sum_{n=0}^{N} |f(n)|$$

$$For\ n\ between\ 0\ to\ N, f(n) <= f(n) + \frac{\mu.e.x(n)}{E}$$

where *filterMag* is the filter magnitude metric, *f(n)* is the nth coefficient of FIR filter F, $\mu$ is the adaptation factor, image of speed, *x(n)* is the nth reference sample, *E* is the total energy of the N samples of reference signal x, and n is an integer between 0 and N .

**Action 202**

The method comprises smoothing the filter magnitude metric. Smoothing the filter magnitude metric may be performed according to

$$filterMagSmoothed = (1 - \tau).filterMag + \tau.filterMagSmoothed$$

where *filterMagSmoothed* is the smoothed filter magnitude, *filterMag* is the filter magnitude metric, and $\tau$ is a time constant. The computing unit 102 may be configured to smooth the filter magnitude metric according to

$$filterMagSmoothed = (1 - \tau).filterMag + \tau.filterMagSmoothed$$

where *filterMagSmoothed* is the smoothed filter magnitude, *filterMag* is the filter magnitude metric, and $\tau$ is a time constant.

**Action 203**

The method comprises creating a filter deviation metric by subtracting the filter magnitude metric from the smoothed filter magnitude metric.

**Action 203**

The method comprises stabilizing the performance of the prediction filter by modulating the prediction filter based on the filter deviation metric. Stabilizing may further comprise looping the filter deviation metric to an adaptation speed control of a training algorithm. Stabilizing the performance of the prediction filter may still further comprise normalizing of the filter deviation metric, *filterDevNorm* by dividing the absolute of the filter deviation metric with the smoothed filter magnitude metric according to

$$filterDevNorm = \frac{|filterDeviation|}{filterMagSmoothed}$$

The computing unit 102 may be configured to stabilize the performance of the prediction filter by normalizing the filter deviation metric, filterDevNorm by dividing the absolute of the filter deviation metric with the smoothed filter magnitude metric according to

$$filterDevNorm = \frac{|filterDeviation|}{filterMagSmoothed}$$

A significant improvement of the system may be to stabilize the predictor while not significantly impact the adaptation speed as will be the case when using a closed loop activity detector AD.
A specific metric is built up which may well represent the dramatic FIR filter divergence as discussed above, in the case where the disruptor signal d correlates to the reference signal x.
In this divergence case, as discussed above, the FIR filter coefficients are going to behave as accumulators rapidly growing in magnitude. Then it is possible to compute an overall image of the FIR filter magnitude by summing the absolute value of each coefficient:

$$filterMag = \sum_{n=0}^{N} |f(n)|$$

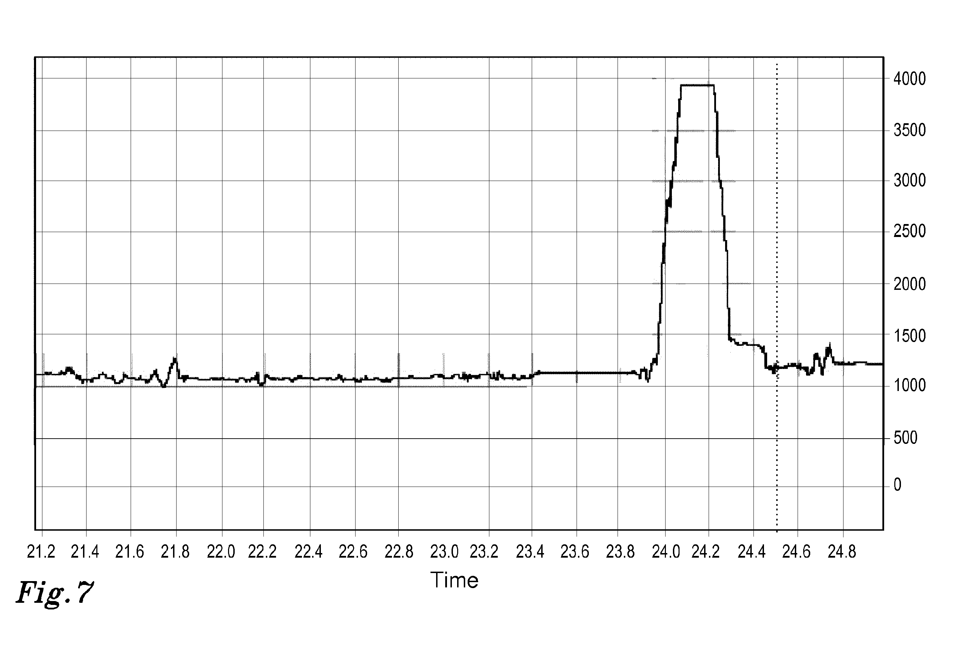

The wave illustrated in **Figure 7** traces this filterMag metric on a given application. The example in figure 7 shows a dramatic divergence of the prediction filter because the disruptor signal d correlating to the reference signal x was not detected by a filtered activity detector AD during ~0.1s. Note that the disruptor signal d was not at a high level but since the convergence speed is set high, the FIR filter overall magnitude diverge by a factor of 4.
From this overall filter magnitude metric, a FIR filter deviation metric is established by computing a smoothed version of the filter overall magnitude, where Tau is a time constant.

$$filterMagSmoothed = (1 - \tau).filterMag + \tau.filterMagSmoothed$$

It is now possible to extract a FIR filter deviation metric by subtracting the filterMagSmoothed from the filterMag:

$$filterDeviation = filterMag - filterMagSmoothed$$

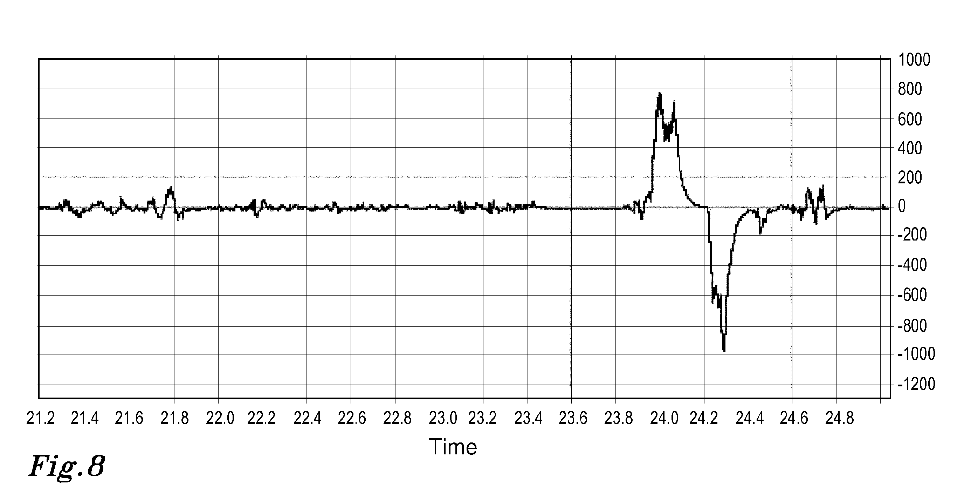

With respect to **Figure 8**, the filterDeviation corresponding to the previous example of figure 7 is shown, where tau is in the range of 0.1 s.

The filter overall magnitude depends directly on the channel G for which the predictor is trained. G is basically unknown and variable thus the filter overall magnitude when filter is trained is also unknown. First, the divergences to prevent are not seen as a given magnitude variation of the filter but as a factor variation of the magnitude. In addition, it is not wanted to prevent normal adaptation of the filter, thus, the filter magnitude may also change by a ratio.

The filterDeviation metric is then normalized by the average of the filter magnitude which is already represented by filterMagSmoothed. One option does not distinguish the polarity of the deviation, thus its absolute is used.

$$filterDevNorm = \frac{|filterDeviation|}{filterMagSmoothed}$$

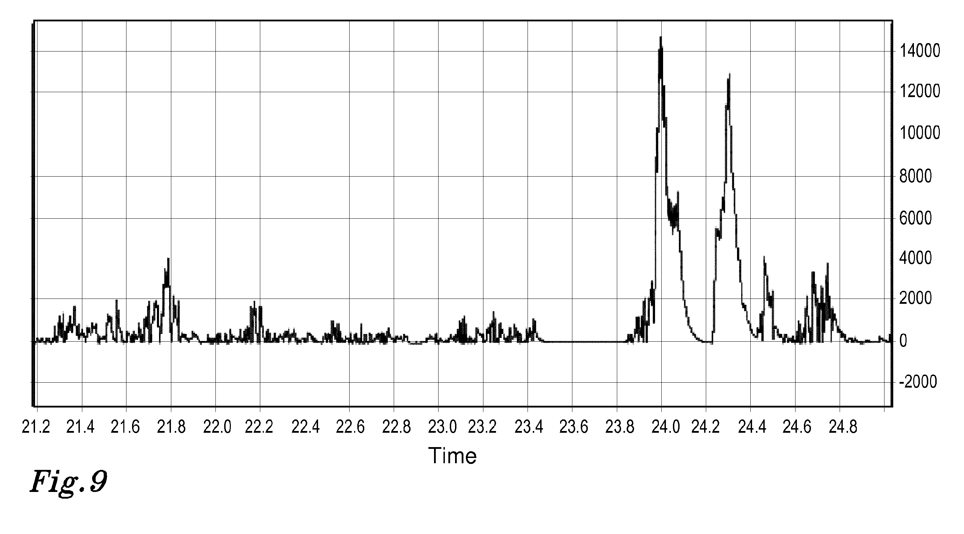

Note that the calculation above is effectively computed if filterMagSmoothed is significant, thus with a large enough value. When filterMagSmoothed is below a given threshold, the filterDevNorm is said to be 0. Still in same application example, **Figure 9** illustrates the filterDevNorm wave. Some other options exist for the filterDevNorm; in some applications it may be needed to prevent large filter magnitude increase, but still allow a larger magnitude decrease. Then, depending on the polarity of filterDeviation, the filterDevNorm may be multiplied by a given factor. There may be some applications interested in computing filterDevNorm with a non-linear function, such as a square function. The use of a non-linear function may magnify the deviation metric for large deviations, but will make it smaller for small deviations.

The metric filterDevNorm may be looped to the speed of the adaptation algorithm. The higher deviation; the lower speed.

For NLMS, the adaptation factor is computed as:

$$\mu m = \mu . filterModulation$$

$\mu$ is still depending on the activity detector AD of the system but is modulated as per filter deviation metric.

The filterModulation modulator may be computed as:

$$filterModulation = 1 - G . filterDevNorm$$

Note that filterModulation is clamped to 0, thus it cannot be negative. G is the loop gain.

Figure 10 is a block diagram for an exemplified embodiment. A prediction filter 101 for stabilizing filter performance is exemplified. The prediction filter 101 comprises a computing unit 102 configured to compute a filter magnitude metric related to the prediction filter. Further, the computing unit 102 is configured to smooth the filter magnitude metric and to create a filter deviation metric by subtracting the filter magnitude metric from the smoothed filter magnitude metric. The computing unit is further configured to stabilize the performance of the prediction filter by modulating the prediction filter based on the filter deviation metric.

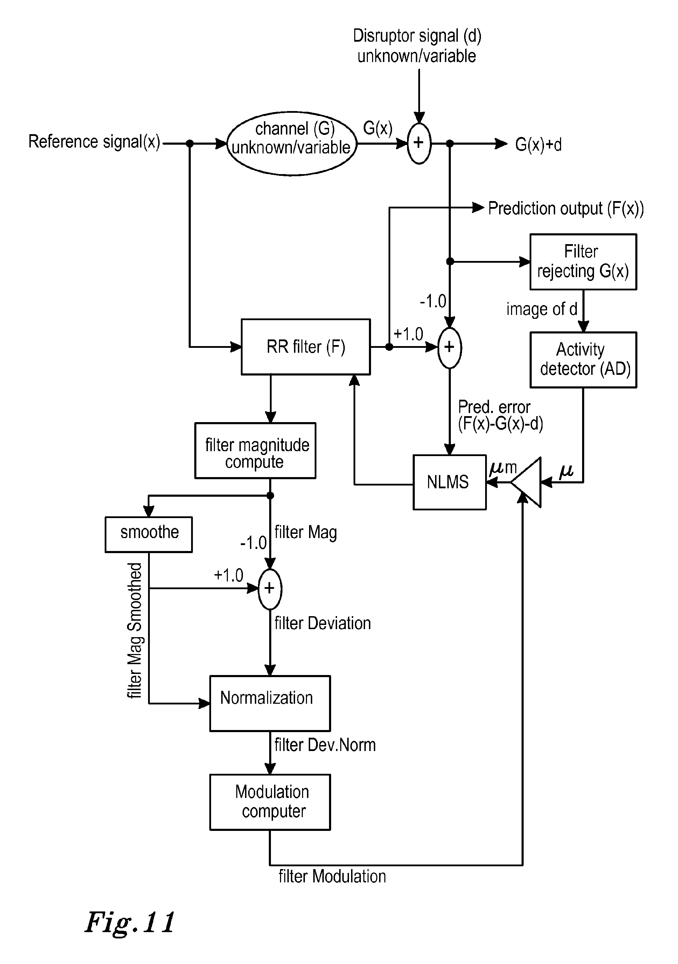

With respect to **Figure 11**, there is now illustrated an overall structure. When the loop is closed, by computing the training factor of the adaptation algorithm as described below, the system will become more stable even if the activity detector fails to detect the disruptor signal d, in particular when the disruptor signal d correlates to reference signal x.

$$\mu m = \mu . filterModulation$$

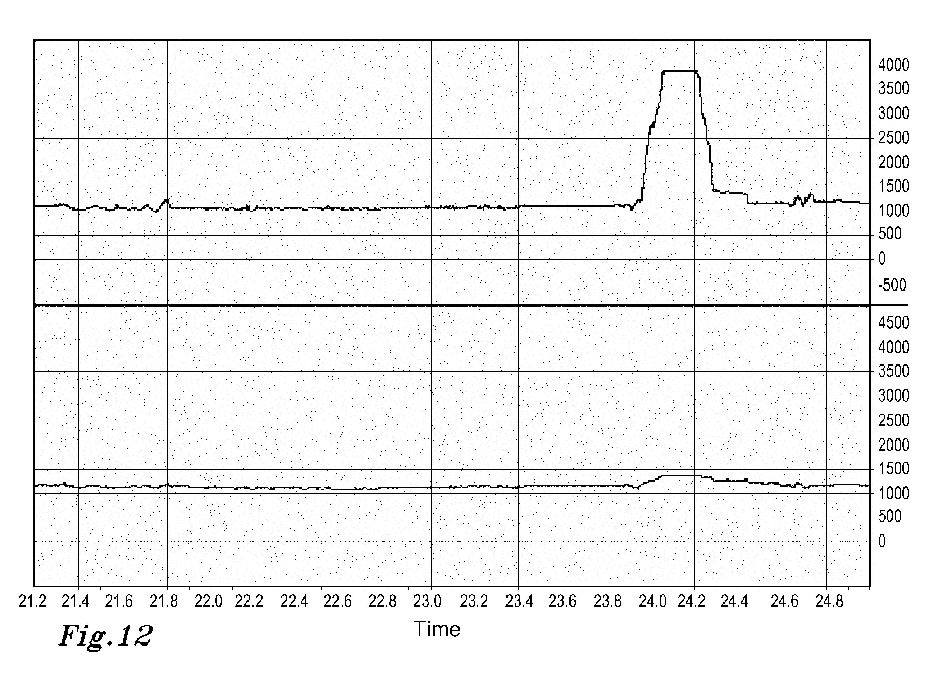

The waves illustrated in **Figure 12** show the overall filter magnitude without, top wave, and with applying embodiments described herein, bottom wave. As seen, the system is no more dramatically diverging.

Embodiments described herein have the following advantages. The performance of the prediction filter is significantly more stable even in the case that the disruptor signal d correlates to a reference signal x. Embodiments herein does not require any closed loop activity detector AD for stability purposes, even if some may be added for any other reason. Because of the absence of any closed loop AD, the initial convergence or any re-convergence are fast. Embodiments herein does not significantly impact negative to the prediction speed, since it bounds to the variability of the filter. The computation requirement remains low.

In the previous description specific details have been set forth, such as particular embodiments for purposes of explanation and not limitation. However, it will be appreciated by one skilled in the art that other embodiments may be employed apart from these specific details. In some instances, detailed descriptions of well-known methods, nodes, interfaces, circuits, and devices are omitted thus as not obscure the description with unnecessary detail.

Those skilled in the art will appreciate that the functions described may be implemented in one or more nodes, e.g. a wireless modem or a wireless device, using hardware circuitry, e.g., analogue and/or discrete logic gates interconnected to perform a specialized function, ASICs, PLAs, etc., and/or using software programs and data in conjunction with one or more digital microprocessors or general purpose computers. Nodes that communicate using the air interface also have suitable radio communications circuitry. Moreover, the technology may additionally be considered to be embodied entirely within any form of computer-readable memory, such as solid-state memory, magnetic disk, or optical disk comprising an appropriate set of computer instructions that would cause a processor to carry out the techniques described herein.

Hardware implementation may include or encompass, without limitation, digital signal processor, DSP, hardware, a reduced instruction set processor, hardware, e.g., digital or analogue circuitry including but not limited to Application Specific Integrated Circuits, ASIC, and/or Field Programmable Gate Arrays, FPGAs, and where appropriate state machines capable of performing such functions.

In terms of computer implementation, a computer unit is generally understood to comprise one or more processors or one or more controllers, and the terms computer, processor, and controller may be employed interchangeably. When provided by a computer, processor, or controller, the functions may be provided by a single dedicated computer or processor or controller, by a single shared computer or processor or controller, or by a plurality of individual computers or processors or controllers, some of which may be shared or distributed. Moreover, the term "processor" or "controller" also refers to other hardware capable of performing such functions and/or executing software, such as the example hardware recited above.

Although the description above comprises many specifics, they should not be construed as limiting but as merely providing illustrations of some presently preferred embodiments. The technology fully encompasses other embodiments which may become apparent to those skilled in the art. Reference to an element in the singular is not intended to mean "one and only one" unless explicitly thus stated, but rather "one or more." All structural and functional equivalents to the elements of the above-described embodiments that are known to those of ordinary skill in the art are expressly incorporated herein by reference and are intended to be encompassed hereby. Moreover, it is not necessary for a device or method to address each and every problem sought to be solved by the described technology for it to be encompassed hereby.

When using the word "comprise" or "comprising" it shall be interpreted as non-limiting, in the meaning of consist at least of.

When using the word action/actions it shall be interpreted broadly and not to imply that the actions have to be carried out in the order mentioned. Instead, the actions may be carried out in any suitable order other than the order mentioned. Further, some action/actions may be optional.

The embodiments herein are not limited to the above described examples. Various alternatives, modifications and equivalents may be used.

Abbreviations

FIR : Finite Impulsive Response filter.
AD : Activity Detector
NLMS : Normalized Least Mean Square
FAP : Fast Affine Projection
x : reference signal
d : disruptor signal
G : channel G transfer function
F : FIR filter transfer function

**Claims**

1. A method in a prediction filter (101) for stabilizing filter performance of the prediction filter (101), the method comprising:

- *computing* (201) a filter magnitude metric related to the prediction filter (101),
- *smoothing* (202) the filter magnitude metric,
- *creating* (203) a filter deviation metric by subtracting the filter magnitude metric from the smoothed filter magnitude metric,
- *stabilizing* (204) the performance of the prediction filter by modulating the prediction filter based on the filter deviation metric.

2. A method according to claim 1, wherein, the stabilizing (204) further comprises,

   - looping the filter deviation metric to an adaptation speed control of a training algorithm.

3. A method according to claim 1 or 2, wherein the filter performance is represented by a plurality of filter magnitude coefficients, and wherein the computing (201) of the filter magnitude metric is performed by summing an absolute value of each of the filter magnitude coefficients according to

$$filterMag = \sum_{n=0}^{N} |f(n)|$$

$$For\ n\ between\ 0\ to\ N, f(n) <= f(n) + \frac{\mu.e.x(n)}{E}$$

where *filterMag* is the filter magnitude metric, *f(n)* is the nth coefficient of FIR filter F, $\mu$ is the adaptation factor, image of speed, *x(n)* is the nth reference sample, *E* is the total energy of the N samples of reference signal x, and n is an integer between 0 and N .

4. A method according to any of claims 1-3, wherein smoothing the filter magnitude metric is performed according to

$$filterMagSmoothed = (1 - \tau).filterMag + \tau.filterMagSmoothed$$

where *filterMagSmoothed* is the smoothed filter magnitude, *filterMag* is the filter magnitude metric, and $\tau$ is a time constant.

5. A method according to any of claims 1-4, wherein, in the stabilizing (204) the performance of the prediction filter further comprises normalizing of the filter deviation metric, *filterDevNorm* by dividing the absolute of the filter deviation metric with the smoothed filter magnitude metric according to

$$filterDevNorm = \frac{|filterDeviation|}{filterMagSmoothed}$$

6. A method according to any of claims 1-5, wherein the prediction filter (101) is a Finite Impulse Response, FIR, filter.

7. A prediction filter (101) for stabilizing filter performance, the prediction filter (101) comprising:

   - a computing unit (102) being configured to compute a filter magnitude metric related to the prediction filter (101), to smooth the filter magnitude metric, to create a filter deviation metric by subtracting the filter magnitude metric from the smoothed filter magnitude metric, and to stabilize the performance of the prediction filter by modulating the prediction filter based on the filter deviation metric.

8. A prediction filter (101) according to claim 7, wherein the computing unit (102) is configured to stabilize performance by looping the filter deviation metric to an adaptation speed control of a training algorithm.

9. A prediction filter (101) according to claim 7 or 8, wherein the filter performance is represented by a plurality of filter magnitude coefficients, and wherein the computing unit (102) is configured to compute the filter magnitude metric by summing an absolute value of each of the filter magnitude coefficients according to

$$filterMag = \sum_{n=0}^{N} |f(n)|$$

$$For\ n\ between\ 0\ to\ N, f(n) <= f(n) + \frac{\mu.e.x(n)}{E}$$

where *filterMag* is the filter magnitude metric, *f(n)* is the nth coefficient of FIR filter F, $\mu$ is the adaptation factor, image of speed, *x(n)* is the nth reference sample, *E* is the total energy of the N samples of reference signal x, and n is an integer between 0 and N .

10. A prediction filter (101) according to any of claims 7-9 wherein the computing unit (102) is configured to smooth the filter magnitude metric according to

$$filterMagSmoothed = (1 - \tau).filterMag + \tau.filterMagSmoothed$$

where *filterMagSmoothed* is the smoothed filter magnitude, *filterMag* is the filter magnitude metric, and $\tau$ is a time constant.

11. A prediction filter (101) according to any of claims 7-10, wherein the computing unit (102) is configured to stabilize the performance of the prediction filter by normalizing the filter deviation metric, *filterDevNorm* by dividing the absolute of the filter deviation metric with the smoothed filter magnitude metric according to

$$|filterDeviation|$$

12. A prediction filter (101) according to any of claims 7-11, wherein the prediction filter (101) is a Finite Impulse Response, FIR, filter.

*Fig.1*

*Fig.2*

Fig.3

*Fig.4*

Fig.5

Fig.6

**Fig.7**

EP 2 706 670 A2

Fig.8

Fig.9

101 — PREDICTION FILTER

102 — COMPUTING UNIT

*Fig.10*

Fig.11

*Fig.12*